# EUROPEAN PATENT APPLICATION

(11) **EP 1 450 397 A2**
(43) Date of publication of application: **25.08.2004**
(21) Application number: 04100724.6
(22) Date of filing: 24.02.2004
(51) Int. Cl.: H01L 21/311

(54) **Wet Clean method PZT Capacitors**

(30) Priority: 24.02.2003 US 374858
(71) Applicant: TEXAS INSTRUMENTS INCORPORATED, Dallas, TX 75265 (US)
(72) Inventor: Hall, Lindsey H, Plano, TX Texas 75093 (US)
(74) Representative: Holt, Michael

(57) **Abstract**

A PZT ferroelectric layer (55) is used to form an integrated capacitor. The PZT ferroelectric layer (55) is sandwiched between various conductive layers (35), (45), (65), (75), (85), and (95). During the etching processes used to form the capacitor, damaged regions (100) are formed on the PZT layer (55). A wet clean process that comprises exposing the PZT layer to phosphoric acid is used to remove the damaged regions (100).

## Description

### FIELD OF THE INVENTION

The invention is generally related to the field of integrated circuit manufacture and more specifically to a method of cleaning PZT capacitors following capacitor formation.

### BACKGROUND OF THE INVENTION

Integrated circuit capacitors are important electronic components used in memory circuits. As used in memory circuits the most important function of the capacitor is the retention of charge. When a charged integrated circuit capacitor loses charge that charge has to be replaced or refreshed. A capacitor that loses charge rapidly will require frequent refresh cycles that add to the complexity of the integrated circuit and its operation. In order to minimize the charge lost from these capacitors it is important to minimize the leakage current that flows through the capacitor dielectric or develop a non-volatile memory that retains its charge.

There is a need in the industry to provide a portable computational device that has a fair amount of memory and logic functions integrated onto the same semiconductor chip. Preferably, this memory will be configured such that if the battery dies, the contents of the memory will be retained, i.e. non-volatile memory. A ferroelectric memory (FeRAM) is a non-volatile memory, which utilizes a ferroelectric material, such as Sr₂Bi₂TaO₉ or Pb(Zr,Ti)O₃ (PZT) as the capacitor dielectric situated between a bottom electrode and a top electrode. Both read and write operations are performed for a FeRAM. The memory size and memory architecture affect the read and write access times of a FeRAM.

The non-volatility of a FeRAM is due to the bistable characteristic of the ferroelectric memory cell. Two types of memory cells are used, a single capacitor memory cell and a dual capacitor memory cell. The single capacitor memory cell (referred to as a 1T/1C or 1C memory cell) requires less silicon area, but is less immune to noise and process variations. Additionally, a 1C cell requires a voltage reference for determining a stored memory state. The dual capacitor memory cell (referred to as a 2T/2C or 2C memory cell) requires more silicon area, and it stores complementary signals allowing differential sampling of the stored information. The 2C memory cell is more stable than the 1C memory cell.

Although leakage currents in a ferroelectric memory are not as critical as a dielectric random access memory, high leakage currents can lead to long-term reliability issues. For example, if the leakage currents are large enough, the typical charge-voltage hysteresis behavior of these ferroelectric capacitors cannot be observed. A number of mechanisms can cause leakage currents to flow through a capacitor. In general one of the more common causes of leakage currents in ferroelectric capacitors is trap assisted tunneling. Traps are introduced into the ferroelectric layer mainly through the presence of defects and impurities. Defects are often introduced into the ferroelectric layer during capacitor formation. In trap assisted tunneling the magnitude of the leakage current is related to the number of traps (and therefore defects) present in the capacitor ferroelectric layer. In order to minimize the magnitude of the leakage current the number of traps (or defects) present in the capacitor ferroelectric must be reduced. It is therefore important that methods exist to reduce the number of defects introduced into the capacitor ferroelectric layer during formation.

It is often the case that large values of capacitance are required for integrated circuit capacitors. Given the area constraints of integrated circuits, materials with high dielectric constants (i.e. high K dielectric materials) are now being used to form the capacitor dielectric layer. Ferroelectric materials have the advantage of having a high K as along with the property of being able to retain charge after the removal of the electric field. PZT ferroelectric materials are more susceptible to process induced damage making the availability of methods to remove this damage more critical. The instant invention is a wet clean method for PZT capacitors that reduces and/or removes process-induced defects without affecting capacitor performance.

### SUMMARY OF THE INVENTION

The instant invention comprises a method for forming a PZT capacitor. Conductive layers are formed on a dielectric layer that is formed over a semiconductor during the formation of an electronic circuit. A PZT layer is formed over the conductive layers and additional conductive layers are formed over the PZT layer. A patterned layer of photoresist is used to etch the additional conductive layers. Using the etched conductive layers as a hard mask the PZT layer and the additional conductive layers are etched using a dry etching process. Dry etching processes will introduce damaged regions in the etched PZT layer. The damaged regions are removed using a wet cleaning process comprising phosphoric acid. The wet cleaning process will remove the damaged layers without substantially attacking the non-damaged regions of the PZT layer. In addition damaged regions in the conductive layers will also be removed.

This and other technical advantages of the instant invention will be readily apparent to one skilled in the art from the following FIGURES, description, and claims.

### BRIEF DESCRIPTION OF THE DRAWINGS

In the drawings:

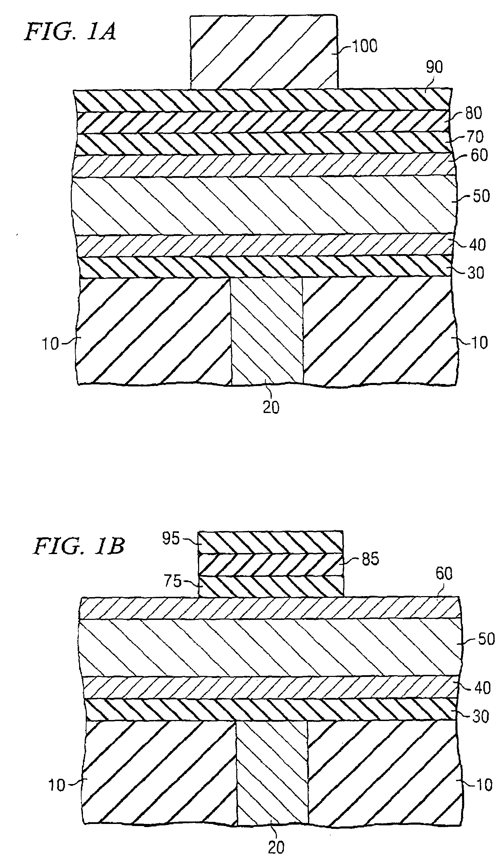

FIGURE 1(A) - FIGURE 1(D) are cross sectional diagrams showing an embodiment of the instant invention.

Corresponding numerals and symbols in the different figures refer to corresponding parts unless otherwise indicated.

### DETAILED DESCRIPTION OF THE INVENTION

The instant invention will be described with reference to Figure 1(a) through Figure 1(d). Illustrated in the Figures is an embodiment of the instant invention comprising a particular capacitor structure. The instant invention should not be limited however to the particular capacitor structure shown in the Figures. The instant invention is applicable to any integrated circuit capacitor structure comprising a lead titanate zirconate Pb(Zr,Ti)O₃ (PZT) capacitor ferroelectric layer.

Shown in Figure 1(a) is a dielectric layer 10 in which a metal contact 20 has been formed. The dielectric layer 10 is formed over a semiconductor containing active electronic devices such as transistors etc. The semiconductor and other features have been omitted from the Figure for clarity. The metal contact 20 comprises a material such as tungsten, aluminum, titanium, titanium nitride or other suitable conductive material and contacts one of the terminals of an electronic device formed in the underlying semiconductor. The capacitor structure will be formed above the metal contact 20 with one of the terminals of the capacitor contacting the metal contact 20. As shown in Figure 1(A) conductive layers 30 and 40 are formed above the metal contact 20 and the dielectric layer 10. In an embodiment of the instant invention the first conductive layer 30 comprises titanium aluminum nitride (TiAlN) and the second conductive layer 40 comprises iridium (Ir). In other embodiments a single conductive layer or any number of conductive layers can be formed above the metal contact 20 and the dielectric layer 10. Following the formation of the conductive layers a PZT ferroelectric layer 50 is formed as shown in Figure 1(A). Following the formation of the PZT ferroelectric layer 50, additional conductive layers 60, 70, 80, and 90 are formed above the ferroelectric layer 50. In an embodiment of the instant invention the conductive layer 60 comprises iridium (Ir), the second conductive layer 70 comprises titanium aluminum nitride (TiAlN), the third conductive layer 80 comprises titanium aluminum oxynitride nitride (TiAlON), and the fourth conductive layer comprises titanium aluminum nitride (TiAlN). In other embodiments a single conductive layer or any number of conductive layers can be formed above the PZT dielectric layer 50. Following the formation of the various conductive layers above the PZT layer 50, a patterned photoresist layer 100 is formed above the conductive layers as shown in Figure 1(A).

As shown in Figure 1(B) the conductive layers 70, 80, and 90 are etched using the patterned photoresist layer 100 as a mask. In the embodiment where the conductive layers 70, 80, and 90 comprise TiAlN, TiAlON, and TiAlN respectively the etching process etches layers 70, 80, and 90 to form the patterned layers 75, 85, and 95 respectively. The etching process comprises a dry plasma etch and stops on layer 60 which comprises iridium. In other embodiments comprising differing numbers and types of conductive layers above the PZT ferroelectric layer, differing numbers of the conductive layers may be etched using the patterned photoresist layer 100 as an etch mask. Following the etching of the conductive layers the patterned photoresist layer 100 is removed as shown in the Figure.

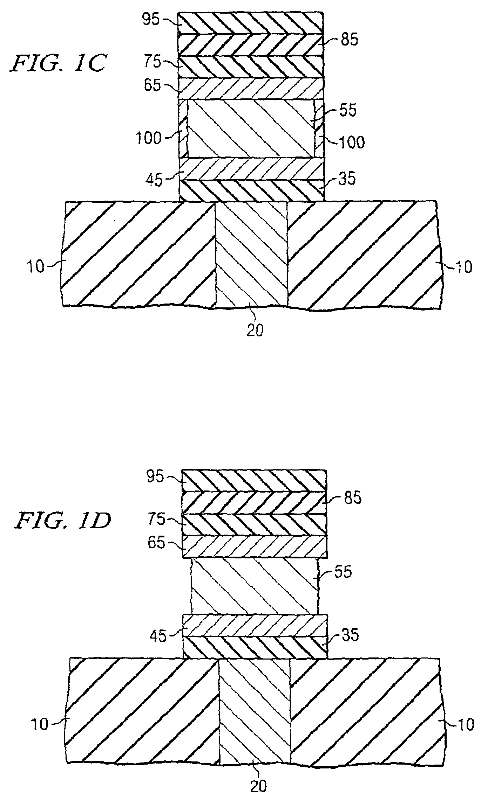

As shown in Figure 1(C) the remaining layers of the capacitor including the PZT layer are etched with a dry plasma etching process using the etched conductive layers as a hardmask to form patterned layers 65, 55, 45 and 35. During the etching process damaged regions 100 are formed in the PZT layer as shown in Figure 1(C). These damage regions can cause leakage currents through the PZT layer as described above. In addition to the damaged regions 100 shown, the etching process can also leave damage and particles on the edges of the patterned conducting layers 95, 85, 75, 65, 45, and 35 that can also introduce leakages currents in the capacitor structure. Following the etching processes used to form the patterned layers 95, 85, 75, 65, 55, 45, and 35 a wet clean process is used to remove the damaged regions 100 and any other damage and particles left after the prior etching processes. According to an embodiment of the instant invention the wet clean process comprises exposing the structure shown in Figure 1(C) to a solution comprising phosphoric acid (H₃PO₄). In a first embodiment the wet clean process comprises using a solution comprising a concentration of 85% phosphoric acid although any concentration of phosphoric acid in the solution can be used. The temperature of the phosphoric acid solution can be between 30°C to 65°C and more preferably at around 40°C. The structure shown in Figure 1(C), including the PZT layer 55, can be exposed to the phosphoric acid solution using a spray, a bath, single wafer processing tools, or any other suitable method. Using the method of the instant invention the phosphoric acid wet clean method will remove the damaged regions 100 without appreciably removing the undamaged regions of the PZT layer as shown in Figure 1(D). In addition the wet clean comprising phosphoric acid will also remove any damaged regions of the conductive layers 95, 85, 75, 65, 45, and 35 as well as any particles left on the structure after the plasma etching process. The wet clean comprising phosphoric acid will not appreciably attack the underlying dielectric layer 10 and metal contact layer 20.

While this invention has been described with reference to illustrative embodiments, this description is not intended to be construed in a limiting sense. For example, the instant invention has been described with reference to specific capacitor structure. The instant invention is not limited to this embodiment however and is applicable to all integrated circuit capacitors that comprise a PZT layer. In addition, the wet clean solution of the instant invention can comprise other chemical species in addition to phosphoric acid. Various modifications and combinations of the illustrative embodiments, as well as other embodiments of the invention, will be apparent to persons skilled in the art upon reference to the description. It is therefore intended that the appended claims encompass any such modifications or embodiments.

## Claims

1. A method to form integrated circuit capacitors, comprising:
providing a dielectric layer;
forming at least one conductive layer on said dielectric layer;
forming a PZT layer on said at least one conductive layer;
forming at least one conductive layer on said PZT layer;
etching said PZT layer; and
exposing said PZT layer to phosphoric acid.

2. The method of claim 1 wherein said exposing said PZT layer to phosphoric acid comprises exposing said PZT layer to a solution comprising a concentration of 85% phosphoric acid.

3. The method of claim 2 wherein said solution comprises a concentration of 85% phosphoric acid is between 30°C and 65°C.

4. The method of claim 3 wherein said solution comprises a concentration of 85% phosphoric acid is around 40°C.

5. A method as claimed in any preceding claim, comprising:
the further step of forming a plurality of conductive layers on said dielectric layer;
and forming said PZT layer on said plurality.

6. A method as claimed in any preceding claim comprising the further step of forming a plurality of conductive layers on said PZT layer.

7. A method as claimed in any preceding claim comprising the further step of etching said conductive layer or layers.

8. The method of any preceding claim wherein a conductive layer comprises iridium, titanium aluminium nitride or titanium oxynitride.

9. A capacitor fabricated in accordance with the method of any preceding claim.

10. A semi-conductor device including a capacitor as claimed in claim 9.
